# EUROPEAN PATENT SPECIFICATION

(11) **EP 1 353 235 B1**
(45) Date of publication and mention of the grant of the patent: **08.09.2004**
(21) Application number: 03007928.9
(22) Date of filing: 08.04.2003
(51) Int. Cl.: G03F 7/30, G03F 7/035

(54) **Method for making lithographic printing plate**
Verfahren zur Erzeugung einer lithographischen Druckplatte
Procédé de fabrication d'une plaque d'impression lithographique

(30) Priority: 08.04.2002 JP 2002105359
(43) Date of publication of application: 15.10.2003
(73) Proprietor: FUJI PHOTO FILM CO., LTD., Kanagawa 250-01 (JP)
(72) Inventor: Higashi, Tatsuji, Yoshida-cho, Haibara-gun, Shizuoka-ken (JP)
(74) Representative: HOFFMANN - EITLE

(56) References cited:
- EP-A- 1 081 554
- EP-A- 1 091 253
- EP-A- 1 096 314
- US-A- 4 882 246
- DATABASE WPI Section Ch, Week 199510 Derwent Publications Ltd., London, GB; Class A89, AN 1995-071170 XP002247622 & JP 06 348037 A (KONICA CORP), 22 December 1994 (1994-12-22)

## Description

### FIELD OF THE INVENTION

The present invention relates to a method for making a lithographic printing plate. More specifically, the present invention relates to a method for making a lithographic printing plate using a replenisher, which inhibits deterioration of developing performance of a developer due to the elapse of a long period of time and repeated use.

### BACKGROUND OF THE INVENTION

An aqueous solution of silicate, phosphate, carbonate, or hydroxide of an alkali metal or an organic amine compound is used as a developer for a photopolymerizable presensitized plate for use in making a lithographic printing plate having a photopolymerizable composition on an aluminum substrate.

For instance, Japanese Un-Examined Patent Publication (hereunder referred to as "J.P. KOKAI") No. Hei 8-248643 discloses a developer having a relatively high pH value and comprising an alkali silicate salt and amphoteric surfactant. However, image portion of the lithographic printing plate is easily damaged by the developer due to high pH of the developer.

Also, for example, J.P. KOKAI No. Sho 61-109052 discloses a developer comprising an alkali agent, a complexing agent, an anionic surfactant, an emulsifying agent and n-alkanoic acid. Another example is described in German Patent No. 1984605 which discloses a developer comprising an alkali agent, a complexing agent, an anionic surfactant, amyl alcohol, and N-alkoxyamine. However, it is difficult to obtain a good printing performance such as printing durability since both the developers have high pH and comprise an organic solvent which causes damages of image area.

This problem could be solved by use of a developer having a relatively low pH. However, such a developer having a relatively low pH poorly dissolves photopolymerizable light-sensitive layer and thus, may cause problems such as a remain of a film in a non-image area of the light-sensitive layer or a generation of crud or precipitation, particularly when the utilized PS plate is an aged one (that is, the plate has been stored for a long time after production).

Generally, the alkaline developer absorbs carbon dioxide in the air to result in the decrease of pH or developing performance or printing durability of the developer changes sequentially to result in deterioration of the developer. In order to keep the developing performance and printing durability at a constant level, it is particularly important to maintain the pH of the developer at a constant value. Therefore, generally, a solution for supplementation of developer, having a higher alkaline concentration than that of developer (hereinafter, referred to as "replenisher") is used to supplement the developer to maintain the pH of the developer at a constant value. In such a supplementation, a required amount of replenisher is added to the developer to maintain the pH of the developer but an excess amount of the total developer overflows from the developing bath. If a replenisher having so high alkaline concentration is used, it would be difficult to conduct fine adjustment of the pH of the developer. Also, it is difficult to handle such a high alkaline solution. Therefore, the alkaline concentration of the replenisher is usually twice to 10 times as much as that of the developer. However, the cost for preparing and transferring such a replenisher is high since the amount to be used for supplementing the developer with such a replenisher is so much. In addition, waste from the process also increases and thus a cost for processing the waste is also high. In addition, a pump used for supply of the replenisher to the developer works many times to thus result in the trouble of the pump. Thus, the pump for supplying the replenisher should be exchanged many times due to its trouble. Moreover, the printing durability of the lithographic printing plate processed using the replenisher having 2 to 10 times as much as the alkaline concentration of the initial developer sequentially deteriorated.

### SUMMARY OF THE INVENTION

Accordingly, the purpose of the present invention is to provide a method for making a lithographic printing plate showing good developing performance after a long-term processing with low cost for developing process and for maintenance of automatic processor, and also with no deterioration of the printing durability.

The inventors of this invention have conducted various investigations and as a result, have succeeded in the achievement of the foregoing object, while making use of the technique having the following construction.

That is, use of replenisher comprising an alkali agent in a concentration of at least 12 times as much as that of the developer makes the amount of replenisher reduced and the printing durability of the lithographic printing plate does not become deteriorated after a long-term processing.

The present invention provides a method for making a lithographic printing plate comprising imagewise exposing to light a presensitized plate useful for making a lithographic printing plate comprising a photopolymerizable composition comprising an ethylenically unsaturated double bond-containing compound, a photopolymerization initiator and a polymer binder on an aluminum substrate and developing the imagewise exposed plate with a developer comprising an alkali agent, wherein the developer is supplemented with a replenisher comprising an alkali agent in a concentration of at least 12 times as much as the initial amount of alkali agent in the developer before development.

The method of the present invention provides a lithographic printing plate which can be prepared at a low cost and show a stable developing performance and good printing durability even after a long-term use.

### DETAILED DESCRIPTION OF THE INVENTION

The method for making a lithographic printing plate according to the present invention will hereunder be described in more detail.

First of all, the developers and replenishers to be used in the method of the present invention will be detailed below.

The developer used in the method of the present invention is an aqueous solution comprising an alkali agent.

Any alkali agent can be utilized in the present invention. Examples of the alkali agents include inorganic alkali agents such as sodium tertiary phosphate, potassium tertiary phosphate, ammonium tertiary phosphate, sodium carbonate, potassium carbonate, ammonium carbonate, sodium bicarbonate, potassium carbonate, ammonium bicarbonate, sodium borate, potassium borate and ammonium borate, sodium hydroxide, potassium hydroxide, lithium hydroxide, and potassium silicate.

For the purpose of assisting the inorganic alkali agent in the solution of the light-sensitive layer, organic alkali agent can be supplementary used in the developer. Examples of organic alkali agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide.

The alkali agent can be used alone or in combination of two or more of them.

The initial amount of the alkali agent in the developer is suitably determined depending on the kind or purpose of the plate, but generally in the range of 0.001 to 0.4 mol/l. The term "initial amount of alkali agent" means the amount of alkali agent in an unused or freshly prepared developer.

The developer of the present invention preferably has pH ranging from 11.0 to 12.6 at 25°C. If the pH of the developer becomes below the range, the developing performance is deteriorated and thus image can not be formed. If the pH of the developer becomes above the range, the exposed portion is damaged during development and thus the printing durability will be lowered. The pH of the developer preferably ranges from 11.3 to 12.5 and more preferably from 11.5 to 12.4.

The developer utilized in the method of the present invention preferably comprises a surfactant in addition to the alkali agent described above. The surfactant in the developer improves the solubility of a non-irradiated portion of the light-sensitive layer of the present invention and decreases the permeability of the developer into an irradiated portion of the light-sensitive layer. Preferred example of the surfactant is a nonionic surfactant comprising a polyoxyalkylene ether group. It is possible to inhibit foaming in the developer and to easily suppress the foam present in the developer even if it foams, by use of such a nonionic surfactant. Also, it is advantageous to use such a nonionic surfactant to reduce scum in the developer since the surfactant shows an ability to dissolve and disperse the compound in the light-sensitive layer into the developer. The following compound represented by the general formula (I) can be suitably utilized as the surfactant comprising a polyoxyalkylene ether group.

R¹-O-(R²-O)ₙH (I)

In formula (I), R¹ represents an optionally substituted alkyl group having 3 to 15 carbon atoms, optionally substituted aromatic hydrocarbon group having 6 to 15 carbon atoms, or optionally substituted heteroaryl ring having 4 to 15 carbon atoms, wherein the substituent on these groups is an alkyl group having 1 to 20 carbon atoms, halogen atom such as Br, Cl, I, aromatic hydrocarbon group having 6 to 15 carbon atoms, aralkyl group having 7 to 17 carbon atoms, alkoxyl group having 1 to 20 carbon atoms, alkoxy-carbonyl group having 2 to 20 carbon atoms, or acyl group having 2 to 15 carbon atoms, R² represents an optionally substituted alkylene group having 1 to 100 carbon atoms, wherein the substituent on the group is an alkyl group having 1 to 20 carbon atoms or aromatic hydrocarbon group having 6 to 15 carbon atoms, and "n" represents an integer of 1 to 100.

In addition, if "n" is an integer of 2 to 100, R² may be the same or different and preferably R² may be two or three groups. Specific examples of such a group include a combination of ethyleneoxy group and propyleneoxy group, a combination of ethyleneoxy group and isopropyloxy group, a combination of ethyleneoxy group and butyleneoxy group, and a combination of ethyleneoxy group and isobutylene group, in which each group may be connected to each other as a random or block copolymer.

In the present invention, the nonionic surfactant comprising a polyoxyalkylene ether group may be used alone or in a combination. An effective amount of the surfactant comprising polyoxyalkylene ether group to be used in a developer is in the range of 0% to 30% by weight and preferably from 2% to 20% by weight. If the amount of the surfactant is too small, the developing performance of the developer is deteriorated. If the amount of the surfactant is in excess, the printing durability is deteriorated.

Moreover, the following surfactants may be added to the developer. Examples of the additional surfactant include a nonionic surfactant including polyoxyethylene alkyl ethers such as polyoxyethylene lauryl ether, polyoxyethylene cetyl ether and polyoxyethylene stearyl ether; polyoxyethylene alkylaryl ethers such as polyoxyethylene octylphenyl ether and polyoxyethylene nonylphenyl ether; polyoxyethylene alkyl esters such as polyoxyethylene stearate; and sorbitan alkyl esters such as sorbitan monolaurate, sorbitan monostearate, sorbitan distearate, sorbitan monooleate, sorbitan sesquioleate and sorbitan trioleate, monoglyceride alkyl esters such as glycerol monostearate and glycerol monooleate; an anionic surfactant including alkylbenzene sulfonic acid salts such as sodium dodecylbenzenesulfonate; alkylnaphthalene sulfonic acid salts such as sodium butylnaphthalenesulfonate, sodium pentylnaphthalenesulfonate, sodium hexylnaphthalenesulfonate and sodium octylnaphthalenesulfonate; alkylsulfuric acid salts such as lauryl sodium sulfate; alkyl sulfonic acid salts such as sodium dodecylsulfonate, and sulfosuccinate salts such as dilauryl sodium sulfosuccinate; and an amphoteric surfactant including alkylbetaines such as laurylbetaine and stearylbetaine; and amino acids type-amphoteric surfactants, and preferred among these are anionic surfactants such as alkylnaphthalene sulfonic acid salts.

The surfactant may be used alone or in any combination of at least two of them. The amount of the surfactant in the developer ranges generally from 0.1 to 20% by weight in terms of the effective component thereof.

The developer according to the present invention may further comprise as occasion demands, other components than those described above. Examples of such components include organic carboxylic acids such as benzoic acid, phthalic acid, p-ethyl benzoic acid, p-n-propyl benzoic acid, p-isopropyl benzoic acid, p-n-butyl benzoic acid, p-t-butyl benzoic acid, p-2-hydroxyethyl benzoic acid, decanoic acid, salicylic acid, 3-hydroxy-2-naphthoic acid ; organic solvents such as isopropyl alcohol, benzyl alcohol, ethyl cellosolve, butyl cellosolve, phenyl cellosolve, propylene glycol, diacetone alcohol ; a chelating agent; a reducing agent; a colorant dye; a pigment; a water softener; and an antiseptic agent.

Next, the replenisher usable in the present invention will be described.

The replenisher of the present invention is characterized in that it has an alkali agent in a concentration of at least 12 times as much as the initial alkali agent in the developer. The same compound as described for alkali agent in the developer can be used as an alkali agent in the replenisher. It is preferable to use the same alkali agent as in the developer, but another alkali agent also can be used. The alkali agent can be used alone or in a combination of two or more alkali agents.

More preferable concentration of the alkali agent in the replenisher is 15 to 50 times as much as the initial amount of alkali agent in the developer, and further preferably, 18 to 30 times as much as the initial amount of the alkali agent in the developer. If the concentration of alkali agent is too high, it is difficult to keep safe in the processing. Therefore, from this point of view, pH of the replenisher is preferably 13.8 or below. Preferably, the pH of the replenisher in the range of 12.6 to 13.8 at 25°C. More preferably, when the pH of the developer is in the range of 11.5 to 12.4 at 25°C, the pH of the replenisher is in the range of 12.6 to 13.8 at 25°C.

In addition, the replenisher preferably comprises a surfactant as in the developer. Examples of the developer include those described in the explanation of the surfactant in the developer. Preferably, the same surfactant as in the developer is used, but it may be possible to use another surfactant. The surfactant can be used alone or in any combination. As in the developer, a nonionic surfactant having a polyoxyalkylene ether group is preferably used. Preferred examples of the surfactant are as described for the developer.

Further, any other surfactant may be used in the replenisher as in the developer. Preferred examples of such a surfactant are described in the explanation of the developer.

The concentration of the surfactant in the replenisher may be the same as that of the developer, but some increase or decrease of the concentration is acceptable. The replenisher preferably comprises the surfactant in an amount ranging from 1 to 30% by weight, more preferably 2 to 20% by weight, and further preferably 3 to 10% by weight. In another embodiment, the concentration of the surfactant in the replenisher is preferably 20 to 600%, more preferably 40 to 400% and further preferably 60 to 200%, as much as the concentration of the surfactant in the developer.

In the method of the present invention to supplement the developer with the replenisher, generally the pH of the developer is used as an index. For example, pH of the developer after a fixed amount of the plate was processed is determined and the pH of the developer is returned to the initial pH by supplementing with a replenisher in an amount sufficient to return the pH to the initial pH of the developer. In addition, if the decrease of the pH of the developer due to the effect of the carbon dioxide gas in the air is observed when no plate is processed, the pH of the developer is returned to the initial pH by supplementing with a replenisher in an amount sufficient to return the pH to the initial pH of the developer.

One embodiment of the method according to the present invention to supplement the developer with the replenisher using an automatic processor is described.
1) Supplementation with the replenisher for the alkali ingredient which has been exhausted in the processing of the plate: the amount of the replenisher used to return the pH of the developer to initial pH of the developer after a predetermined area of plate was processed is determined to obtain an amount of the replenisher per the processed area (ml/m²) and the developer is supplemented with the replenisher in this amount.
2) Sequential supplementation with the replenisher for the alkali ingredient which has been exhausted by carbon dioxide gas in the air (when no plate is processed but electric power is alive): even when no plate is processed, if electric power of automatic processor is alive, the processor works to keep the temperature of the developer at a constant level and the developer circulates and carrier roll rotates. Thus, the pH of the developer decreases by the effect of carbon dioxide in the air and supplementation of developer with a replenisher is necessary to return the pH to the initial pH of the developer. The amount of the replenisher necessary to return the decreased pH by the carbon dioxide in the air to the initial pH per time (ml/hr) is determined and the developer is supplemented with the replenisher in this amount.
3) Sequential supplementation with the replenisher for the alkali ingredient which has been exhausted by carbon dioxide gas in the air (when no plate is processed and electric power is cut down): when the electric power of automatic processor is cut down, pH of the developer is decreased by the effect of carbon dioxide gas in the air. Thus, supplementation with replenisher is necessary to return the pH to the initial pH of the developer. The amount of replenisher necessary to return the decreased pH by the carbon dioxide in the air to the initial pH per time (ml/hr) is determined and the developer is supplemented with the replenisher in this amount.

Next, the presensitized plate used in the method of the present invention will be described.

The photopolymerizable composition which consists the light-sensitive layer of the PS plate in the present invention essentially comprises ethylenically unsaturated double bond-containing compound, photopolymerization initiator, and polymer binder, and optionally comprises additives such as coloring agent, plasticizer, and thermal polymerization inhibitor .

The ethylenically unsaturated double bond in the ethylenically unsaturated double bond-containing compound can be addition polymerized to cross-link or cure the compound when the photopolymerizable composition is exposed to active light.

The compound comprising the addition polymerizable or ethylenically unsaturated double bond may be selected from the group consisting of compounds comprising at least one, preferably two or more terminal ethylenically unsaturated bonds, which the compounds are in the form of, for example, a monomer, prepolymer (i.e., oligomer such as a dimer and trimer), copolymer and a mixture thereof.

Examples of the monomer and copolymer comprising an ethylenically unsaturated double bond include an ester of unsaturated carboxylic acid (e.g., acrylic acid, methacrylic acid, itaconic acid, crotonic acid, isocrotonic acid, and maleic acid) and aliphatic polyol, and an amide of unsaturated carboxylic acid and aliphatic polyamine

Examples of the ester of unsaturated carboxylic acid and aliphatic polyol include an acrylic acid ester such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythyritol diacrylate, pentaerythyritol triacrylate, pentaerythyritol tetraacrylate, dipentaerythyritol diacrylate, dipentaerythyritol pentaacrylate, dipentaerythyritol hexaacrylate, sorbitol triacrylate, sorbitol tetraacrylate, sorbitol pentaacrylate, sorbitol hexaacrylate, tri(acryloyloxyethyl)isocyanulate, polyester acrylate oligomer.

Examples of methacrylic acid ester include tetramethylene glycol dimethacrylate, triethylene glycol dimethacrylate, neopentyl glycol dimethacrylate, trimethylolpropane trimethacrylate, trimethylolethane methacrylate, ethylene glycol dimethacrylate, 1,3-butanediol dimethacrylate, hexanediol dimethacrylate, pentaerythyritol dimethacrylate, pentaerythyritol trimethacrylate, pentaerythyritol tetramethacrylate, dipentaerythyritol dimethacrylate, dipentaerythyritol hexamethacrylate, dipentaerythyritol pentamethacrylate, sorbitol trimethacrylate, sorbitol tetramethacrylate, bis[p-(3-methacryloxy-2-hydroxypropoxy)phenyl]dimethylmethane, bis-[p-(methacryloxyethoxy)phenyl]dimethylmethane.

Examples of itaconic acid ester include ethylene glycol diitaconate, propylene glycol diitaconate, 1,5-butanediol diitaconate, 1,4-butanediol diitaconate, tetramethylene glycol diitaconate, pentaerythyritol diitaconate, sorbitol tetraitaconate.

Examples of crotonic acid ester include ethylene glycol dicrotonate, tetramethylene glycol dicrotonate, pentaerythyritol dicrotonate, sorbitol tetradicrotonate.

Examples of isocrotonic acid ester include ethylene glycol diisocrotonate, pentaerythyritol diisocrotonate, sorbitol tetraisocrotonate.

Examples of maleic acid ester include ethylene glycol dimaleate, triethylene glycol dimaleate, pentaerythyritol dimaleate, sorbitol tetramaleate and the like. Further, mixtures of the aforementioned ester monomers are also included.

Examples of amide of aliphatic polyamine compound and unsaturated carboxylic acid include methylenebis-acrylamide, methylenebis-methacrylamide, 1,6-hexamethylenebis-acrylamide, 1,6-hexamethylenebis-methacrylamide, diethylenetriaminetrisacrylamide, xylylenebisacrylamide, xylylenebismethacrylamide.

Other examples include vinylurethane compound comprising two or more polymerizable vinyl groups in a molecule, prepared by an addition reaction of a vinyl monomer having a hydroxyl group represented by the following formula (A) with a polyisocyanate compound having two or more isocyanate groups as disclosed in Japanese Patent Publication for Opposition Purpose (hereunder referred to as "J.P. KOKOKU") No. Sho 48-41708.

CH₂=C(R³)COOCH₂CH(R⁴)OH (A)

wherein R³ and R⁴ each represents H or CH₃.

Also, urethane acrylates as described in J.P. KOKAI No. Sho 51-37193, J.P. KOKOKU No. Hei 2-32293, polyfunctional acrylates or methacrylates such as epoxyacrylate prepared from epoxy resin and (meth)acrylic acid, and polyester acrylates as described in J.P. KOKAI No. Sho 48-64183, J.P. KOKOKU No. Sho 49-43191, and J.P. KOKOKU No. Sho 52-30490, can be utilized as the compound comprising an ethylenically unsaturated double bond. In addition, a photo-setting monomer and oligomer as described in "Bulletin of Japan Adhesive Association Vo1.20, No.7, p. 300-308 (1984)" can be utilized. The amount of the ethylenically unsaturated double bond-containing compound ranges 5% to 80% by weight and preferably from 30% to 70% by weight on the basis of the total weight of the light-sensitive layer.

The initiator for photopolymerization usable in the light-sensitive layer in the PS plate of the present invention can be selected from various initiators for photopolymerization reported in many patents and publications, or from various combinations of two or more initiators for photopolymerization (photoinitiation system), depending on the wavelength of the light source to be used. Specific examples thereof will be described below, but not limited thereto.

There have been proposed various photoinitiation systems which can be used for visible light rays having 400nm or longer, Ar laser (488 nm, 514.5 nm), secondary harmonics of semiconductor laser, or SHG-YAG laser (532 nm), He-Ne laser, IR semiconductive laser (800 to 900 nm) as a light source. For instance, a certain dye capable of being photolytically reduced such as Rose Bengale, Eosine, and Erythrosine (U.S. Patent No. 2,850,445); a combination system of a dye and an initiator such as a combined initiator system comprising a dye and an amine (J.P. KOKOKU No. Sho 44-20189); a system comprising hexaarylbiimidazole, a radical initiator and a dye (J.P. KOKOKU No. Sho 45-37377); a system comprising a hexaarylbiimidazole and a p-dialkylaminobenzylidene ketone (J.P. KOKOKU No. Sho 47-2528 and J.P. KOKAI No. Sho 54-155292); a system comprising a cyclic cis- α-dicarbonyl compound and a dye (J.P. KOKAI No. Sho 48-84183); a system comprising a substituted triazine and a merocyanine dye (J.P. KOKAI No. Sho 54-15102); a system comprising a 3-keto-substituted coumarin compound and an active halogen atom-containing compound (J.P. KOKAI No. Sho 52-112681, J.P. KOKAI No. Sho 58-15503); a system comprising biimidazole, styrene derivative, and thiol (J.P. KOKAI No. Sho 59-140203); a system comprising an organic peroxide compound and a pigment (J.P. KOKAI No. Sho 59-1504, J.P. KOKAI No. Sho 59-140203, J.P. KOKAI No. Sho 59-189340, J.P. KOKAI No. Sho 62-174203, J.P. KOKOKU No. Sho 62-1641, U.S. Patent No. 4766055); a system comprising a dye and an active halogenated compound (J.P. KOKAI No. Sho 63-258903, J.P. KOKAI No. Hei 2-63054 and the like); a system comprising a dye and a borate compound (J.P. KOKAI No. Sho 62-143044, J.P. KOKAI No. Sho 62-150242, J.P. KOKAI No. Sho 64-13140, J.P. KOKAI No. Sho 64-13141, J.P. KOKAI No. Sho 64-13142, J.P. KOKAI No. Sho 64-13143, J.P. KOKAI No. Sho 64-13144, J.P. KOKAI No. Sho 64-17048, J.P. KOKAI No. Hei 1-229003, J.P. KOKAI No. Hei 1-298348, J.P. KOKAI No. Hei 1-138204 and the like); a system comprising a dye having a rhodanine ring and a radical generator (J.P. KOKAI No. Hei 2-179643, J.P. KOKAI No. Hei 2-244050); a system comprising a titanocene and 3-keto-substituted coumarin compound (J.P. KOKAI No. Sho 63-221110); a system comprising titanocene, xanthene dye, and an addition polymerizable compound having an ethylenically unsaturated double bond and an amino group or a urethane group (J.P. KOKAI No. Hei 4-221958, J.P. KOKAI No. Hei 4-219756); a system comprising a titanocene and a specific merocyanine dye (J.P. KOKAI No. Hei 6-295061); and a system comprising a titanocene and a dye having a benzopyran ring (J.P. KOKAI No. Hei 8-334897).

In addition, a laser having a wavelength ranging from 360 nm to 430 nm (violet laser) has been developed and also, a photoinitiation system highly sensitive to the wavelength of 450 nm or shorter has been developed. Therefore, such a photoinitiation system also can be utilized. Examples thereof include a system comprising a cationic dye/borate (J.P. KOKAI No. Hei 11-84647), a system comprising a merocyanine dye/titanocene (J.P. KOKAI No. 2000-147763), a system comprising a carbazole dye/titanocene (Japanese Patent Application No. Hei 11-221480) . In particular, a system comprising a titanocene compound is preferably used in the present invention in view of its high sensitivity.

In the present invention, any titanocene compound can be utilized, but a suitable titanocene compound can be selected from various titanocene compounds including, for example, those described in J.P. KOKAI No. Sho 59-152396 and J.P. KOKAI No. Sho 61-151197. More specifically, examples of the titanocene compound include di-cyclopentadienyl-Ti-di-chloride, di-cyclopentadienyl-Ti-bis-phenyl, di-cyclopentadienyl-Ti-bis-2,3,4,5,6-pentafluorophen-1-yl, di-cyclopentadienyl-Ti-bis-2,3,5,6-tetrafluorophen-1-yl, di-cyclopentadienyl-Ti-bis-2,4,6-trifluorophen-1-yl, di-cyclopentadienyl-Ti-bis-2,6-di-fluorophen-1-yl, di-cyclopentadienyl-Ti-bis-2,4-di-fluorophen-1-yl, di-methylcyclopentadienyl-Ti-bis-2,3,4,5,6-tetrafluorophen-1-yl, di-methylcyclopentadienyl-Ti-bis-2,6-difluorophen-1-yl, di-cyclopentadienyl-Ti-bis-2,6'-difluoro-3-(pyr-1-yl)-phen-1-yl.

Moreover, it is known that a photoinitiation activity of the above described photopolymerization initiator can be improved by optionally adding to the initiator a hydrogen-donating compound such as thiol compounds, e.g., 2-mercaptobenzthiazole, 2-mercaptobenzimidazole, and 2-mercaptobenzoxazole, and amine compounds, e.g., N-phenylglycine, N,N-dialkylaminoarylcarboxylic acid alkyl ester.

The amount of the photopolymerization initiator (or system) to be used ranges from 0.05 to 100 parts by weight, preferably from 0.1 to 70 parts by weight, and more preferably from 0.2 to 50 parts by weight, per 100 parts by weight of ethylenically unsaturated double bond-containing compound.

The binder polymer used in the light-sensitive layer of the PS plate of the present invention should be a film-forming material as well as an alkali developer-soluble material. Therefore, an organic polymer compound that is soluble or swellable in an alkali water may be used. Examples of organic polymer compound include any alkaline soluble resin such as acrylic resin or urethane resin, but polyurethane resin is preferred because of its high durability.

Examples of polyurethane resins include those described in J.P. KOKOKU Nos. Hei 7-120040, Hei 7-120041, Hei 7-120042, Hei 8-12424, J.P. KOKAI Nos. Sho 63-287944, Sho 63-287947, Hei 1-271741, and J.P. Application Nos. Hei 11-286965, Hei 11-297142, Hei 11-305734, Hei 11-309585, Hei 11-352691, 2000-35369, and 2000-35370 are useful for the present invention.

The polyurethane resin binder used in the present invention will be detailed below.

The polyurethane resin binder as an essential component of the light-sensitive layer of the present invention is a polymer comprising a structure, as a basic skeleton, derived from a reaction product of at least one diisocyanate compound represented by formula (1)' and at least one diol compound represented by formula (1)".

OCN-Xo-NCO (1)'

HO-Yo-OH (1)ʺ

wherein, Xo and Yo independently represent a residue of a divalent organic group.

Among the polyurethane resin binders used in the light-sensitive layer of the present invention, preferred are polyurethane resins comprising carboxyl groups in an amount of 4.0 meq/g or more. Preferred polyurethane resins in the present invention are those having a structure, as a basic skeleton, derived from a reaction product of at least one diisocyanate compound represented by formula (1) and at least one diol compound represented by formula (2), (3) or (4), and/or a structure derived from a reaction product obtained by opening tetracaboxylic acid dihydrate with diol compound.

OCN―L₁―NCO (1)

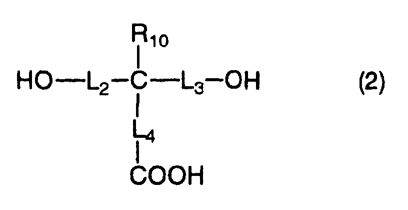

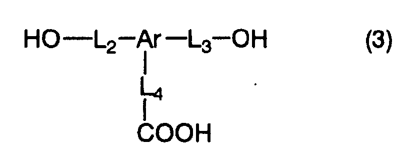

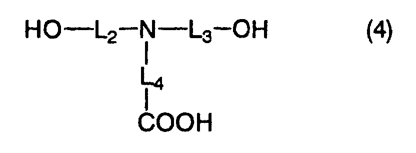

wherein, L₁ represents a divalent aliphatic or aromatic hydrocarbon group. If necessary, L₁ may have other functional groups, which never react with isocyanate groups, such as carbonyl, ester, urethane, amide and/or ureide groups.

R₁₀ represents a hydrogen atom or an alkyl, aralkyl, aryl, alkoxy or aryloxy group, which may have a substituent (such as cyano, nitro, halogen atom (-F, -Cl, -Br, -I), -CONH₂, -COOR₁₁, -OR₁₁, -NHCONHR₁₁₃ -NHCOOR₁₁, -NHCOR₁₁, -OCONHR₁₁ (wherein R₁₁ represents an alkyl group having 1 to 10 carbon atoms or an aralkyl group having 7 to 15 carbon atoms), preferably a hydrogen atom, an alkyl group having 1 to 8 carbon atoms or an aryl group having 6 to 15 carbon atoms.

L₂, L₃ and L₄ may be the same or different and each represents a single bond or a divalent aliphatic or aromatic hydrocarbon group, which may have a substituent (preferred examples thereof are alkyl, aralkyl, aryl, alkoxy and/or halogeno groups), preferably an alkylene group having 1 to 20 carbon atoms or an arylene group having 6 to 15 carbon atoms and more preferably an alkylene group having 1 to 8 carbon atoms. Moreover, L₂, L₃ and L₄ may, if needed, comprise other functional groups, which never react with isocyanate groups, such as carbonyl, ester, urethane, amide, ureide and/or ether groups. In this respect, two or three substituents out of R₁₀, L₂, L₃ and L₄ may form a ring.

Ar represents a trivalent aromatic hydrocarbon group, which may have a substituent, and preferably an aromatic group having 6 to 15 carbon atoms.

### A) Isocyanate compounds

Specific examples of di-isocyanate compounds represented by formula (1) include the following compounds; aromatic di-isocyanate compounds such as 2,4-tolylene di-isocyanate, dimmer of 2,4-tolylene di-isocyanate, 2,6-tolylene di-isocyanate, p-xylylene di-isocyanate, m-xylylene di-isocyanate, 4,4'-diphenyl-methane di-isocyanate, 1,5-naphthylene di-isocyanate and 3,3'-dimethylbiphenyl-4,4'-di-isocyanate; aliphatic di-isocyanate compounds such as hexamethylene di-isocyanate, trimethyl-hexamethylene di-isocyanate, lysine di-isocyanate and dimeric acid di-isocyanate; alicyclic di-isocyanate compounds such as isophorone di-isocyanate, 4,4'-methylene-bis(cyclohexyl isocyanate), methyl cyclohexane-2,4 (or 2,6) di-isocyanate and 1,3-(isocyanate methyl) cyclohexane; and di-isocyanate compounds as reaction products of diols with di-isocyanates such as an addition product of one mole of 1,3-butylene glycol with 2 moles of tolylene di-isocyanate.

### B) Diol compounds comprising carboxyl group

Specific examples of diol compounds having carboxyl groups and represented by the foregoing formula (2), (3) or (4) include those listed below: 3,5-dihydroxy benzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl)acetic acid, bis(4-hydroxyphenyl)acetic acid, 2,2-bis(hydroxymethyl)acetic acid, 4,4-bis(4-hydroxy-phenyl)pentanoic acid, succinic acid, N,N-dihydroxy-ethyl glycine and N,N-bis(2-hydroxyethyl)-3-carboxy-propionamide.

Moreover, examples of tetra-carboxylic acid di-anhydrides preferably used for the preparation of at least one diol compound having at least one carboxyl group are those represented by the following general formulas (5), (6), (7): 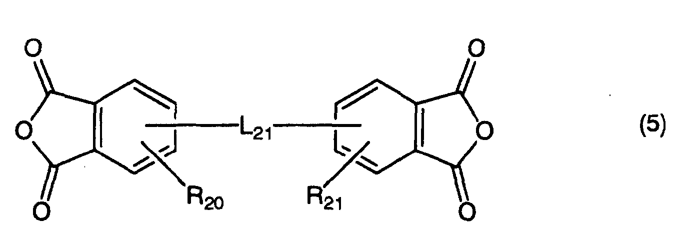 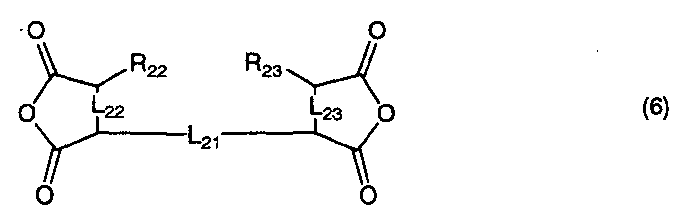 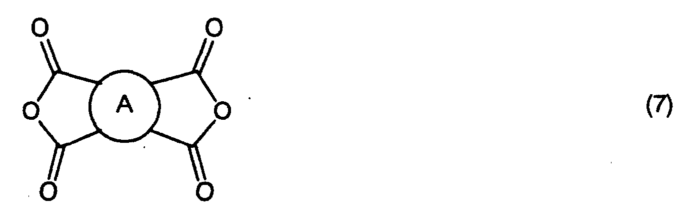 wherein, L₂₁ represents a single bond, a divalent aliphatic or aromatic hydrocarbon group, which may have a substituent (preferred examples thereof are alkyl, aralkyl, aryl, alkoxy, ester and amide groups or halogen atoms), -CO-, -SO-, -SO₂-, -O- or -S-. The substituent preferably represents a single bond, a divalent aliphatic hydrocarbon group having 1 to 15 carbon atoms, -CO-, -SO₂-, -O- or -S-. R₂₀, R₂₁ may be the same or different and each represents a hydrogen atom or an alkyl, aralkyl, aryl, alkoxy or halogeno group and preferably a hydrogen atom, an alkyl group having 1 to 8 carbon atoms, an aryl group having 6 to 15 carbon atoms, an alkoxy group having 1 to 8 carbon atoms or a halogeno group. In this respect, two out of L₂₁, R₂₀ and R₂₁ may be bonded together to form a ring. R₂₂ and R₂₃ may be the same or different and each represents a hydrogen atom or an alkyl, aralkyl, aryl or halogeno group and preferably a hydrogen atom, an alkyl group having 1 to 8 carbon atoms or an aryl group having 6 to 15 carbon atoms. In this respect, two out of L₂₁, R₂₂ and R₂₃ may be bonded together to form a ring. L₂₂ and L₂₃ may be the same or different and each represents a single bond, a double bond or a divalent aliphatic hydrocarbon group and preferably a single bond, a double bond or a methylene group. A represents a mononuclear or polynuclear aromatic ring and preferably an aromatic ring having 6 to 18 carbon atoms.

Specific examples of compounds represented by the general formula (5), (6) or (7) include those listed below:

Specific examples of the compounds include aromatic tetra-carboxylic acid dianhydrides such as pyromellitic acid dianhydride, 3,3',4,4'-benzophenone-tetra-carboxylic acid dianhydride, 3,3',4,4'-diphenyl-tetra-carboxylic acid dianhydride, 2,3,6,7-naphthalene-tetracarboxylic acid dianhydride, 1,4,5,8-naphthalene-tetra-carboxylic acid dianhydride, 4,4'-sulfonyl-diphthalic acid dianhydride, 2,2-bis(3,4-di-carboxy-phenyl) propane dianhydride, bis(3,4-dicarboxy-phenyl) ether dianhydride, 4,4'-[3,3'-(alkyl-phosphoryl-di-phenylene)-bis(imino-carbonyl)] di-phthalic acid di-anhydride, adduct of hydroquinone di-acetate with trimellitic acid anhydride and adduct of diacetyldiamine with trimellitic acid anhydride; alicyclic tetracarboxylic acid dianhydrides such as 5-(2,5-dioxo-tetrahydrofuryl)-3-methyl-3-cyclohexene-1,2-dicarboxylic acid anhydride (EPICHLON B-4400 available from Dainippon Ink and Chemicals, Inc.), 1,2,3,4-cyclopentane-tetracarboxylic acid dianhydride, 1,2,4,5-cyclohexane-tetracarboxylic acid dianhydride and tetrahydrofuran-tetracarboxylic acid dianhydride; and aliphatic tetra-carboxylic acid dianhydrides such as 1,2,3,4-butane-tetracarboxylic acid dianhydride and 1,2,4,5-pentane-tetracarboxylic acid dianhydride.

The structural units derived from a tetracarboxylic acid dianhydride and a diol compound can be introduced into a polyurethane resin according to the following methods:
a) A method comprises the steps of cleaving a tetracarboxylic acid dianhydride with a diol compound to form a compound carrying a terminal alcohol group and then reacting the compound with a di-isocyanate compound.
b) A method comprises the steps of reacting a di-isocyanate compound with an excess diol compound to give a urethane compound carrying a terminal alcohol group and then reacting the urethane compound with a tetracarboxylic acid dianhydride.

Examples of diol compound used in the method are described below. Specific examples of such diol compounds are ethylene glycol, diethylene glycol, triethylene glycol, tetraethylene glycol, polyethylene glycol, propylene glycol, dipropylene glycol, polypropylene glycol, neopentyl glycol, 1,3-butylene glycol, 1,6-hexanediol, 2-butene-1,4-diol, 2,2,4-trimethyl-1,3-pentandiol, 1,4-bis-β-hydroxy-ethoxy-cyclohexane, cyclohexane dimethanol, tricyclodecane dimethanol, hydrogenated bisphenol A, hydrogenated bisphenol F, ethylene oxide adducts of bisphenol A, ethylene oxide adducts of bisphenol F, ethylene oxide adducts of hydrogenated bisphenol A, ethylene oxide adducts of hydrogenated bisphenol F, propylene oxide adducts of bisphenol A, propylene oxide adducts of bisphenol F, propylene oxide adducts of hydrogenated bisphenol A, propylene oxide adducts of hydrogenated bisphenol F, hydroquinone dihydroxy-ethyl ether, p-xylene glycol, dihydroxy-ethyl sulfone, bis(2-hydroxyethyl)-2,4-tolylene dicarbamate, 2,4-tolylene-bis(2-hydroxyethyl-carbamide), bis(2-hydroxyethyl)-m-xylylene dicarbamate and bis(2-hydroxyethyl) isophthalate.

### C) Other diol compounds

The polyurethane compounds usable in the present invention are preferably those having a structure derived from a reaction product of polyether diol compounds, polyester diol compounds or polycarbonate diol compounds.

Examples of polyether compounds include compounds represented by the following general formulas (A), (B), (C), (D), (E) and a random copolymer of propylene oxide and ethylene oxide having a terminal hydroxy group.

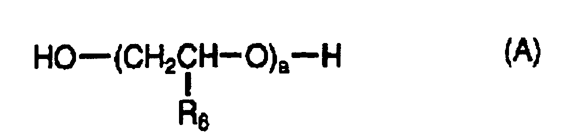

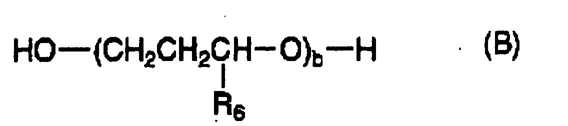

HO―(CH₂CH₂CH₂CH₂-O)_{c}―H (C)

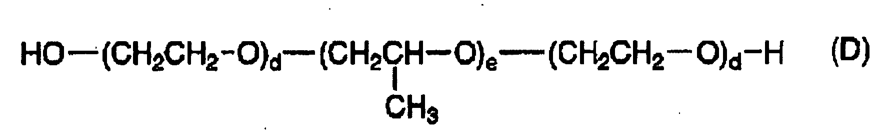

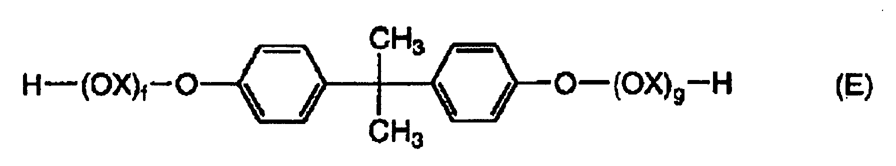

wherein, R₆ represents a hydrogen atom or a methyl group and X represents the following groups.

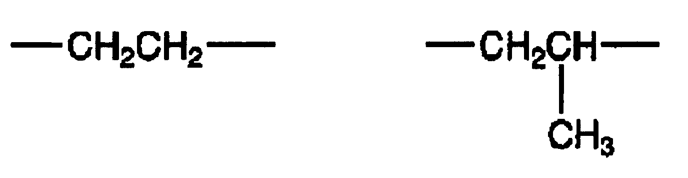

Moreover, each of a, b, c, d, e, f, g in Formulas (A) to (E) represents an integer of not less than 2 and preferably an integer ranging from 2 to 100.

Specific examples of polyether diol compounds represented by formula (A) or (B) include the following compounds: diethylene glycol, triethylene glycol, tetraethylene glycol, pentaethylene glycol, hexaethylene glycol, heptaethylene glycol, octaethylene glycol, di-1,2-propylene glycol, tri-1,2-propylene glycol, tetra-1,2-propylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol, tri-1,3-butylebe glycol, hexa-1,3-butylene glycol, polyethylene glycol having an average molecular weight of 1000, polyethylene glycol having an average molecular weight of 1500, polyethylene glycol having an average molecular weight of 2000, polyethylene glycol having an average molecular weight of 3000, polyethylene glycol having an average molecular weight of 7500, polypropylene glycol having an average molecular weight of 400, polypropylene glycol having an average molecular weight of 700, polypropylene glycol having an average molecular weight of 1000, polypropylene glycol having an average molecular weight of 2000, polypropylene glycol having an average molecular weight of 3000, polypropylene glycol having an average molecular weight of 4000.

Specific examples of polyether diol compounds represented by formula (C) include PTMG650, PTMG1000, PTMG20000, and PTMG3000 (available from Sanyo Chemical Industries, Co. Ltd.).

Examples of polyether diol compounds represented by formula (D) include Newpol PE-61, Newpol PE-62, Newpol PE-64, Newpol PE-68, Newpol PE-71, Newpol PE-74, Newpol PE-75, Newpol PE-78, Newpol PE-108, Newpol PE-128, and Newpol PE-61 (available from Sanyo Chemical Industries, Co. Ltd.).

Examples of polyether diol compounds represented by formula (E) include Newpol BPE-20, Newpol BPE-20F, Newpol BPE-20NK, Newpol BPE-20T, Newpol BPE-20G, Newpol BPE-40, Newpol BPE-60, Newpol BPE-100, Newpol BPE-180, Newpol BP-2P, Newpol BPE-23P, Newpol BPE-3P, Newpol BPE-5P (available from Sanyo Chemical Industries, Co. Ltd.).

Examples of random copolymer of propylene oxide and ethylene oxide having a terminal hydroxy group include Newpol 50HB-100, Newpol 50HB-260, Newpol 50HB-400, Newpol 50HB-660, Newpol 50HB-2000, Newpol 50HB-5100 (available from Sanyo Chemical Industries, Co. Ltd.).

The polyurethane resin used in the present invention can be synthesized by adding a conventional active catalyst selected according to the reactivity of the starting materials to the isocyanate compound and diol compound in an aprotic solvent and heating the mixture. The molar ratio of the di-isocyanate compound to the diol compounds preferably ranges from 0.8:1 to 1.2:1. In this respect, if isocyanate groups remain at the termini of the resulting polymer, the polymer is treated with alcohols or amines to thus ultimately synthesize a polyurethane resin free of any remaining isocyanate group.

The polyurethane resin preferably comprises carboxyl groups in an amount of 0.4 meq/g or more, more preferably from 0.4 to 3.5 meq/g.

The weight average molecular weight of the polyurethane resin is preferably 1000 or more and more preferably from 5,000 to 500,000.

The polymer can be used alone or in any combination. The amount of the polymer in the light-sensitive layer may range from about 5 to 95 % by weight and preferably from about 10 to 90 % by weight.
i) As specific examples of polyurethane resins more preferably used herein, there may be listed the following compounds, but the present invention is not restricted to these specific examples at all. The majority of the specific examples thereof are indicated or specified by the combinations of di-isocyanate compounds and diol compounds used. In addition, the carboxyl group content is expressed in terms of the acid value.

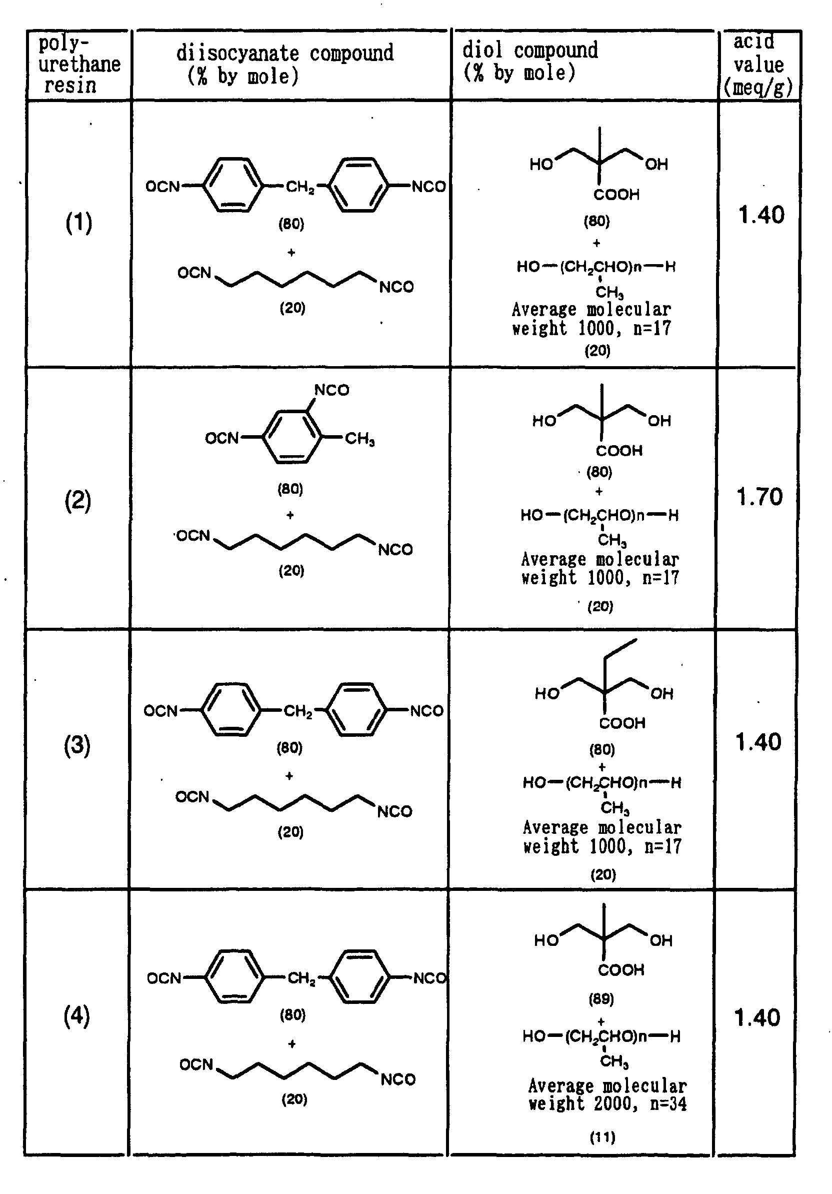

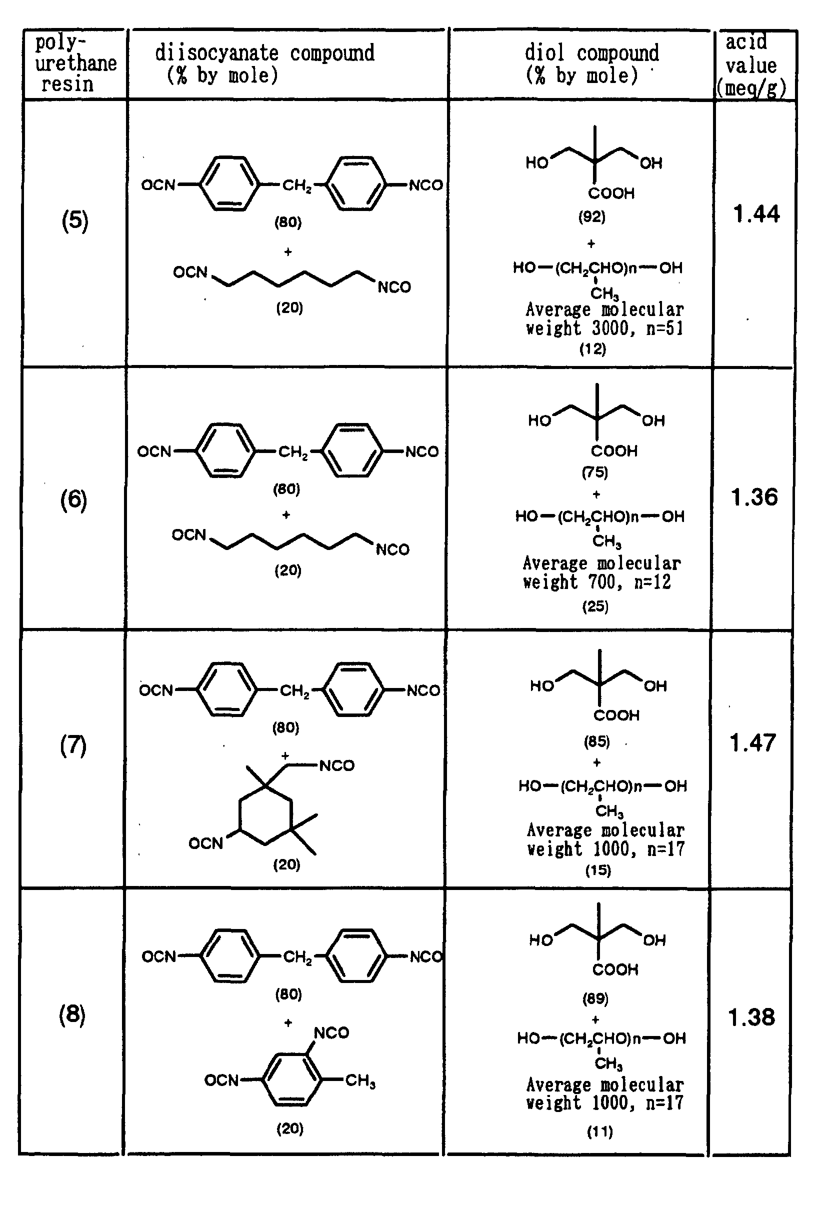

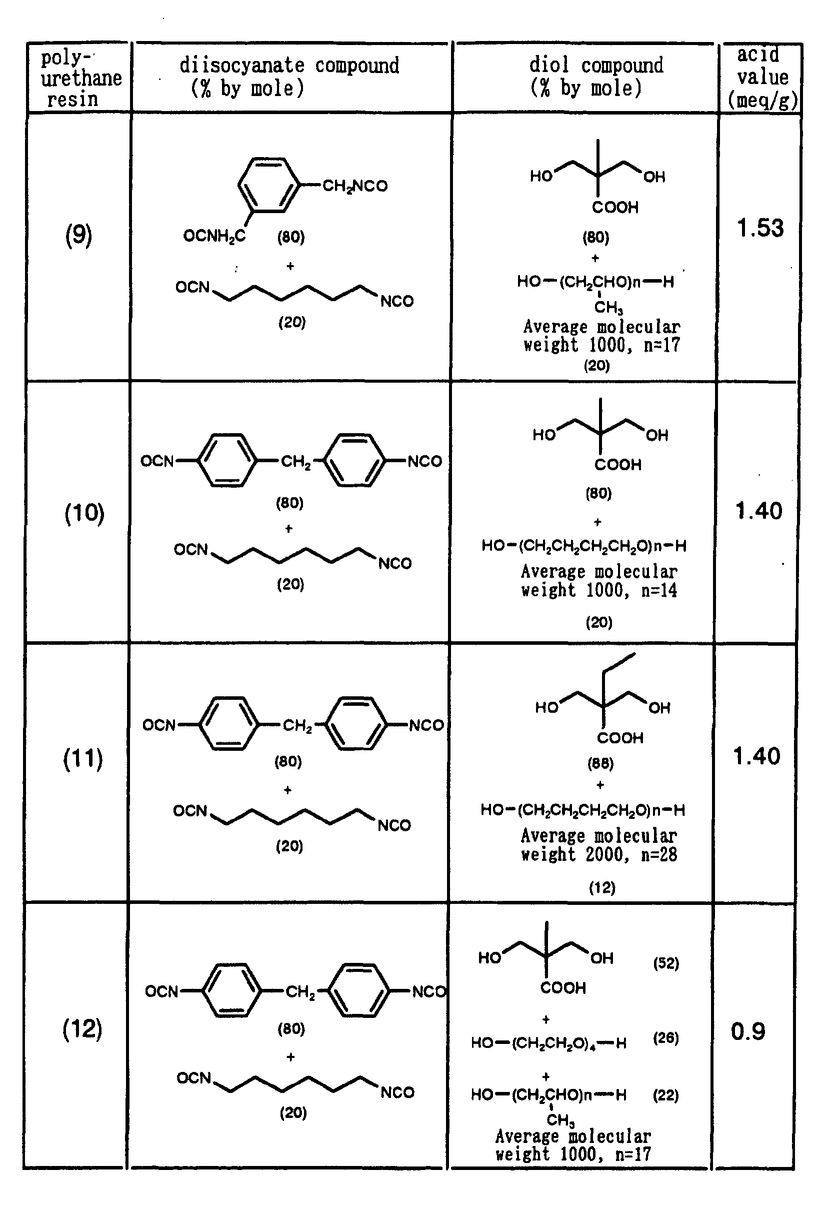

The strength of the cured film of the light-sensitive layer can be improved by introducing a radical reactive group into the side chain of the above-mentioned polymer. Examples of the functional groups that can readily cause addition-polymerization reaction are ethylenically unsaturated double bond group, amino group, and epoxy group; examples of the functional groups that can be formed into radicals by light exposure are mercapto group, thiol group, halogen atoms, triazine structure, and onium salt structure; and examples of polar groups are carboxyl group and imide group. The ethylenically unsaturated double bond groups such as acryl group, methacryl group, allyl group and styryl group are particularly preferable as the functional groups that can readily cause addition-polymerization reaction, and in addition, other functional groups selected from the group consisting of amino group, hydroxyl group, phosphonic acid group, phosphoric acid group, carbamoyl group, isocyanate group, ureido group, ureylene group, sulfonic acid group, and ammonio group are also useful.

It is preferable that the above-mentioned polyurethane resin binder be controlled to have an appropriate molecular weight and acid value in order to maintain the developing performance of a photopolymerizable composition. In consideration of development using the developer of the present invention, it is preferable to use any of the above-mentioned polymers with a weight-average molecular weight (by GPC method, polystyrene standard) of from 5,000 to 30,000.

The polyurethane resin binder can be incorporated into the photopolymerizable composition in any suitable amounts. However, if the amount of the organic polymer exceeds 90%, undesirable problems will arise, for instance, the strength of images formed by development may be insufficient. In light of this, the amount of the polyurethane resin binder is preferably in the range of from 10 to 90%, more preferably from 30 to 80%. It is preferable that the weight ratio of the photopolymerizable ethylenically unsaturated double bond-containing compound to the polyurethane resin binder is in the range of 1:9 to 9:1, more preferably 2:8 to 8:2, and further preferably 3:7 to 7:3.

In addition to the foregoing fundamental components, a small amount of thermal polymerization inhibitor is desirably contained in the photopolymerizable composition to inhibit undesired thermal polymerization of the polymerizable ethylenically unsaturated double bond-containing compound during preparation or storage of the photopolymerizable composition. Examples of such thermal polymerization inhibitors include hydroquinone, p-methoxyphenol, di-t-butyl-p-cresol, pyrogallol, t-butyl catechol, benzoquinone, 4,4'-thiobis(3-methyl-6-t-butylphenol), 2,2'-methylenebis(4-methyl-6-t-butylphenol), N-nitrosophenyl hydroxylamine cerium salt and N-nitrosophenyl hydroxylamine aluminum salt. The amount of the thermal polymerization inhibitor is preferably from about 0.01 to about 5% based on the total weight of the photopolymerizable composition. In addition, the photopolymerizable composition may optionally comprise, for example, higher fatty acid derivatives such as behenic acid and behenic acid amide when necessary. To effectively eliminate the polymerization inhibitory effect of oxygen, such higher fatty acid derivatives may be localized in the surface portion of the light-sensitive layer at the drying step for the formation of the light-sensitive layer. The amount of the higher fatty acid derivatives is preferably from about 0.5 to about 10% based on the total weight of the photopolymerizable composition.

Furthermore, the composition may further comprise a coloring agent for pigmenting the resulting light-sensitive layer. Examples of the coloring agent include pigments such as phthalocyanine pigments (C.I. Pigment Blue 15:3, 15:4, 15:6), azo pigments, carbon black, and titanium oxide; and dyes such as Ethyl Violet, Crystal Violet, azo dyes, anthraquinone dyes and cyanine dyes. The amount of the coloring agent including such pigments and dyes is preferably from about 0.5 to about 20% based on the total weight of solid content in the obtained light-sensitive layer.

Moreover, the photopolymerizable composition may further comprise inorganic fillers and plasticizers such as dioctyl phthalate, dimethyl phthalate and tricresyl phosphate for improving the physical properties of the resultant cured film. The amount of such additives including the inorganic fillers and plasticizers is preferably 10% or less of the total weight of solid content in the obtained light-sensitive layer.

To provide the light-sensitive layer on a substrate, which will be described later, the photopolymerizable composition is dissolved in various kinds of organic solvents to prepare a coating liquid and then the coating liquid is applied onto the surface of the substrate. Examples of the solvents include acetone, methyl ethyl ketone, cyclohexane, ethyl acetate, ethylene dichloride, tetrahydrofuran, toluene, ethylene glycol monomethyl ether; ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimetylformamide, dimethyl sulfoxide, γ-butyrolactone, methyl lactate, and ethyl lactate. These solvents may be used alone or in combination. The concentration of the solid content in the coating liquid is suitably from 1 to 50% by weight.

To improve the surface quality of the coated surface, the photopolymerizable composition for use in the light-sensitive layer may further comprise a surfactant.

When the coating liquid for the light-sensitive layer is applied, the coating amount is preferably from about 0.1 to about 10 g/m², preferably from 0.3 to 5 g/m², and more preferably from 0.5 to 3 g/m², after it is dried.

Furthermore, the PS plate for use in the present invention may further comprise a protective layer or overcoat layer such as an oxygen barrier layer (hereinafter, referred to as oxygen barrier protection layer) comprising a water-soluble vinyl polymer as the main component that is overlaid on the light-sensitive layer.

Examples of the water-soluble vinyl polymers for use in the oxygen barrier protection layer include a polyvinyl alcohol which may be partially substituted with ester, ether and acetal; and a copolymer comprising such a partially substituted vinyl alcohol unit and an unsubstituted vinyl alcohol unit in such a substantial amount that can impart the required water-solubility to the resultant copolymer. In the protection layer, polyvinyl alcohols hydrolyzed to the extent of 71 to 100% and have a degree of polymerization of 300 to 2400 are preferably used. Specific examples of the commercially available polyvinyl alcohol products are PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-220, PVA-224, PVA-217EE, PVA-217E, PVA-220E, PVA-224E, PVA-405, PVA-420, PVA-613, and L-8, which are made by KURARAY Co., Ltd. Examples of the above-mentioned copolymers preferably used in the oxygen barrier protection layer include polyvinyl acetate chloroacetate or propionate, polyvinyl formal, polyvinyl acetal and copolymer thereof, which are preferably hydrolyzed to the extent of 88 to 100%. In addition to the above, polyvinyl pyrrolidone, gelatin, and gum arabic are also effectively used for the oxygen barrier protection layer. These polymers may be used alone or in combination.

When the oxygen barrier protection layer is provided by coating, purified water is preferably used alone as a solvent, or in combination with alcohols such as methanol and ethanol, and ketones such as acetone and methyl ethyl ketone. It is proper that the solid content in the coating liquid for formation of the oxygen barrier protection layer be in the range of 1 to 20% by weight.

The oxygen barrier protection layer may further comprise known additives such as a surfactant for improving the coating characteristics and a water-soluble plasticizer for enhancing the physical properties of the obtained layer.

Examples of the above-mentioned water-soluble plasticizer include propionamide, cyclohexanediol, glycerin, and sorbitol. Water-soluble (meth)acrylic polymers may be added.

The coating amount for the oxygen barrier protection layer is suitably in the range of about 0.1 to about 15 g/m², preferably in the range of about 1.0 to about 5.0 g/m² after being dried.

Hereinafter, the substrate for the presensitized plate of usable in the present invention will be described.

The aluminum substrate usable in the present invention will be described. The aluminum substrate usable in the present invention desirably consists of an aluminum having a high dimensional stability, an alloy thereof with silicon, copper, manganese, magnesium, chromium, zinc, lead, bismuth or nickel, or a plastic film or a paper which is laminated or deposited with an aluminum or aluminum alloy. Generally, the thickness of the substrate ranges from about 0.05 mm to about 1 mm. Besides, a composite sheet as disclosed in J.P. KOKAI No. Sho 48-18327 is also preferably used in the present invention.

The surface of the aluminum substrate is treated as described below. (Surface graining)

Preferred surface graining methods of aluminum plates include mechanical surface graining, chemical etching, and electrolytic graining as disclosed in J.P. KOKAI No. Sho 56-28893. The surface graining methods further include, for instance, an electrochemical graining in an electrolyte such as hydrochloric acid or nitric acid, and a mechanical graining such as a wire brush graining wherein an aluminum surface is scrabbled with a metal wire, a ball graining wherein an aluminum surface is grained with an abrasive ball and abrasive, a brush graining wherein an aluminum surface is grained with a nylon brush and abrasive. Moreover, these methods can be used alone or in a combination. Among them, a suitable surface graining method used in the present invention is the electrochemical method wherein the surface is grained chemically in an electrolyte such as hydrochloric acid or nitric acid with an electric current density ranging from 100 C/dm² to 400 C/dm². More specifically, electrolysis is preferably conducted in 0.1% to 50% of hydrochloric acid or nitric acid at 20 °C to 100 °C for 1 second to 30 minutes with an electric current density ranging from 100 C/dm² to 400 C/dm².

The thus grained aluminum substrate may be further chemically etched with an acid or an alkali. It is not industrially advantageous to use an acid as an etching agent since it takes a long time to destroy the micro structure of the plate, but use of an alkali as the etching agent solves this problem.

Suitable alkali agents usable in the present invention include sodium hydroxide, sodium carbonate, sodium aluminate, sodium metasilicate, sodium phosphate, potassium hydroxide and lithium hydroxide. A preferable concentration of the alkali agent ranges from 1% to 50% and a preferable temperature for the treatment with the alkali agent ranges from 20 to 100°C. In addition, a preferred condition for the treatment can be selected so that an amount of the dissolved aluminum becomes in the range of 5 g/m³ to 20 g/m³.

In order to remove a smut remained on the etched surface of an aluminum plate, the plate may be washed with an acid. Examples of the acid to be used include nitric acid, sulfuric acid, phosphoric acid, chromic acid, hydrofluoric acid and fluoboric acid. In particular, preferred smut-removing methods after electrochemical surface graining include a method to contact the plate with 15% to 65% by weight of sulfuric acid solution at 50 to 90°C as disclosed in J.P. KOKAI No. Sho 53-12739, and a method of alkali etching as disclosed in J.P. KOKOKU No. Sho 48-28123.

The aluminum substrate used in the present invention preferably has the surface roughness ranging from 0.3 to 0.7µm.

### (Anodization)

The thus treated aluminum substrate is preferably further subjected to an anodization treatment. The anodization can be conducted by any conventional method known in the art. More specifically, an anodized layer can be formed on the surface of an aluminum substrate by passing a direct or alternating current therethrough in an aqueous solution or non-aqueous solution (i.e., in an electrolyte) comprising sulfuric acid, phosphoric acid, chromic acid, oxalic acid, sulfamic acid, benzenesulfonic acid or a combination thereof.

The conditions for the anodization can be variously changed depending on the kind of the electrolyte used. But, in general, the anodization is preferably performed in an electrolyte having a concentration ranging from 1% to 80% by weight, at a temperature ranging from 5 to 70°C, with a current density ranging from 0.5 A/dm² to 60 A/dm² and a voltage ranging from 1 V to 100 V for 10 seconds to 100 seconds.

Among the anodization treatments, particularly a method to anodize in sulfuric acid using a high current density described in U.K. Patent No.1,412,768, and a method to anodize using phosphoric acid as an electrolyte described in U.S. Patent No.3,511,661 are preferred.

The amount of the anodized layer is preferably in the range of 1 g/m² to 10 g/m². If it is less than 1 g/m², the resulting lithographic printing plate has insufficient printing durability and the non-image portion thereof is easily damaged. If it is higher than 10 g/m², it requires a large amount of electricity to produce the plate to result in an economical disadvantage. More preferable amount ranges from 1.5 g/m² to 7 g/m² and most preferably from 2 g/m² to 5 g/m².

Moreover, the aluminum plate may be subjected to a sealing treatment after the surface-graining and anodization treatments. Such a sealing treatment is performed by immersing the aluminum plate in a hot water or a hot aqueous solution containing an inorganic or organic salt or by treating the plate in a steam bath. In addition, the aluminum plate may be further subjected to other treatments such as a surface treatment with an alkali metal silicate and a dipping treatment to dip the substrate into an aqueous solution comprising a potassium fluorozirconate or a phosphonic acid salt.

The PS plate of the present invention can be prepared by forming the intermediate layer and the light-sensitive layer described above on the thus surface-treated aluminum substrate in this order. But the PS plate may further comprise an organic or inorganic undercoating layer that is interposed between the substrate and the light-sensitive layer, to improve the adhesiveness of the image or to improve the developing performance of non-imaging area..

The PS plate of the present invention is imagewise exposed to a conventional active light such as carbon arc lamps, high pressure mercury lamps, xenon lamps, metal halide lamps, fluorescent lamps, tungsten lamps, halogen lamps, helium-cadmium laser, argon ion laser, FD·YAG laser (532nm), helium-neon laser, semiconductor rays (350 nm to 900 nm) and YAG laser (1064nm). Then, the plate was developed with a developer to form an image on the surface of the aluminum plate.

After being imagewise exposed to light and before being developed, the plate may be heated at 50°C to 200°C for 1 second to 5 minutes in order to enhance the degree of polymerization of the photopolymerizable light-sensitive layer.

Typically, an overcoat layer having an oxygen barrier property is coated on a photosensitive layer of the PS plate of the present invention as described above. Such an overcoat layer may be removed simultaneously with the remove of the non-irradiated portion of the light-sensitive layer with a developer, or may be removed with water or hot water before removing the non-irradiated portion of the photosensitive layer with a developer. Such water or hot water may comprise preservatives as described in J.P. KOKAI No. Hei 10-10754 and organic solvents as described in J.P. KOKAI No. Hei 8-278636.

The development of the exposed plate with the developer described above may be conducted under the conventional condition, that is, by immersing the imagewise exposed plate in the developer at 0 to 60°C, preferably at 15 to 40°C and by rubbing the plate with a brush.

In addition, in the case that the development process is conducted using an automatic processor, the developing performance of the developer used therein (capability of the developer to sufficiently develop the plate) may be recovered by adding a replenisher or a fresh developer when the developer becomes exhausted after a large number of plates are treated.

The thus treated plate is then, generally treated with water, a rinse comprising a surfactant, and/or a solution for desensitizing the plate to grease comprising gum arabic, starch derivatives and the like, as described in J.P. KOKAI Nos. Sho 54-8002, Sho 55-115045, and Sho 59-58431. The plate of the present invention may be subjected to various combinations of the treatments.

The thus treated plate may be further subjected to a heat treatment such as a burning or to a treatment after an exposure to light as described in J.P. KOKAI No. 2000-89478 to improve the printing durability of the plate.

Thus obtained lithographic printing plate is set on an offset press and then is used for printing.

### Examples

Hereinafter, the present invention will be explained more specifically by Examples, but the present invention is not limited thereto.

### [Examples 1 to 3, Comparative example 1]

A 1S aluminum plate having a thickness of 0.30 mm was surface-grained with a No.8 nylon brush and a suspension of 800 mesh pumice stone in water and then sufficiently washed with water. After the plate was etched by immersing in an aqueous solution of 10% sodium hydroxide for 60 seconds at 70°C, the plate was washed with running water. Then the plate was washed with 20% HNO₃ to neutralize it and washed with water. Then, an electrolytic graining of the plate was conducted in a 1% aqueous solution of nitric acid using a rectangle alternating continuous wave voltage with an anode electric amount of 300 coulomb/dm² under the condition of V_{A}=12.7V. The roughness of the surface of the plate determined with an experimental device: Surfcom available from Tokyo Seimitu Co. Ltd., with a needle having a tip diameter of 2µm, was 0.45µm (Ra). The plate was then immersed in a 30% H₂SO₄ for 2 minutes at 55°C to desmut the surface. Then, the plate was anodized in a 20% aqueous solution of H₂SO₄ at 33°C by placing a cathode on the grained surface using an electric current density of 5A/dm² for 50 seconds to obtain a substrate having an anodized layer of which thickness was 2.7g/m².

A highly sensitive photopolymerizable composition 1 described below was coated on the thus treated aluminum plate so that the dried weight thereof became 1.5 g/m², and then the plate was dried at 100°C for 1 minute to form a light-sensitive layer.

| (Photopolymerizable composition 1) | |
|---|---|
| Ethylenically unsaturated double bond-containing compound (A1) | |
| | 2.0 part by weight |
| Polyurethane resin binder (No.12) | 2.0 part by weight |
| Sensitizer (C1) | 0.2 part by weight |
| Initiator for photopolymerization (D1) | 0.2 part by weight |
| ε -Phthalocyanine (F1) dispersion | 0.02 part by weight |
| Fluorine atom-containing nonionic surfactant, Megafac F-177 (Dainippon Ink and Chemicals, Inc.) | 0.02 part by weight |
| Methyl ethyl ketone | 10.0 part by weight |
| Propylene glycol monomethyl ether acetate | 10.0 part by weight |

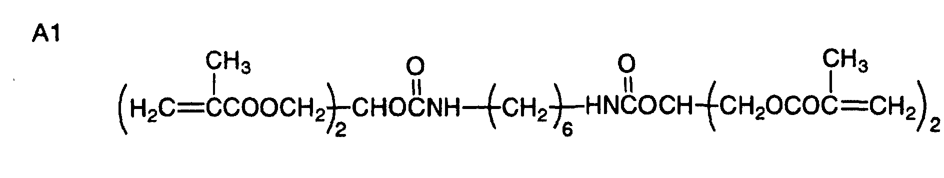

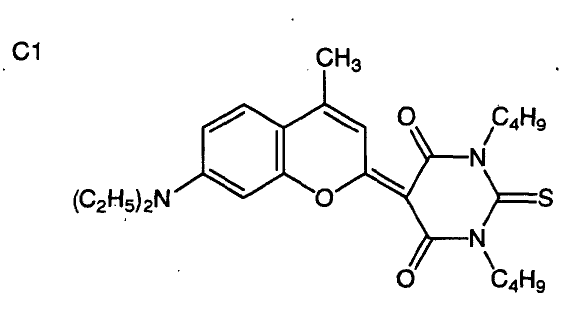

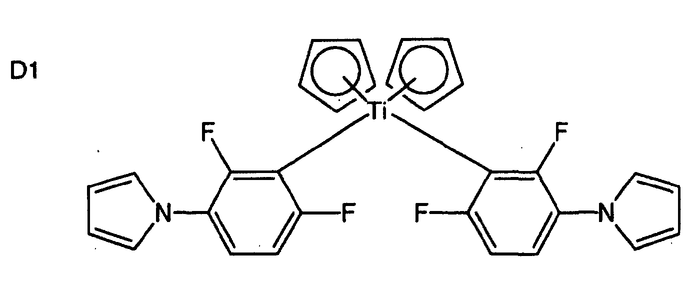

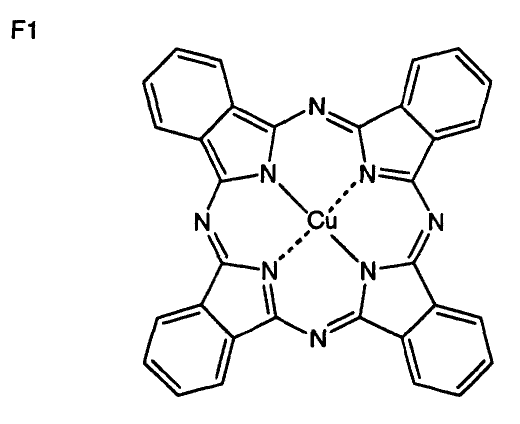

A 5% by weight of an aqueous solution of polyvinyl alcohol (available from Crare, PVA 105, the degree of saponification was 98% by mole and the degree of polymerization was 500) was coated on the photosensitive layer so that the dried weight of the polyvinyl alcohol became 2.5 g/m² and the coating was dried at 120°C for 2 minutes to obtain a PS plate.

The PS plate was exposed to light with 200 µJ/cm² of FD·YAG laser (532nm, Agfa, Polaris 100) under the conditions, dot images (with an increased dot percent from 2% to 99% by 1%) and solid image were subjected to scanning at a density of 1016 dpi and 100 lines/inch (1 inch = 2.54 cm). Then, the plate was subjected to a standard treatment in an automatic processor (InterPlater 85HD, available from G&J, developing rate: 1.35 m/min, initial amount of developer: 40 L, the machine has a system to remove the oxygen barrier layer with water after preheating) comprising Developer 1 and a finishing gum liquid FP-2W (available from Fuji Photo Film Co. Ltd.). Preheating condition for the plate was as follows; the temperature on the surface of plate was 115°C, the developing temperature was 25°C, and the immersing time in the developer was about 20 seconds.

The constitution and pH at 25°C of developer and replenisher, the amount of replenisher, the frequency of trouble of the pump (that is, the frequency of exchange of the pump) during one year use, and printing durability are shown in Tables 1 and 2.

The amount of replenisher was calculated based on the amount to supplement the alkali ingredient in the developer which has been exhausted in the processing of the plate and the amount to sequentially supplement the alkali ingredient in the developer which has been exhausted by carbon dioxide gas in the air as described below and then the calculated amount was input to the software of automatic processor InterPlater 85HD (available from G&J).
1) The amount of the replenisher to be used for supplementation of the alkali ingredient in the developer which has been exhausted in the processing of the plate: the amount used to return the pH of developer to 12.0 after 100 m² of plate being treated for 3 hours was determined.
2) The amount of the replenisher to be used for sequential supplementation of the alkali ingredient in the developer which has been exhausted by the effect of carbon dioxide gas in the air (when no plate was processed but electric power was alive): the electric power of automatic processor was switched on and the machine was kept on stand-by for 72 hours (the temperature of the developer was kept at 25°C, the developer was circulated and the carrier roll was rotated) and then the amount of replenisher necessary to return the decreased pH to pH 12.0 was determined.
3) The amount of the replenisher for sequential supplementation of the alkali ingredient in the developer which has been exhausted by the effect of carbon dioxide gas in the air (when no plate was processed and electric power was cut down): the electric power of automatic processor was switched off for 72 hours and then the amount of replenisher necessary to return the decreased pH to pH 12.0 was determined.

In the automatic processor Inter Plater 85HD (G&J Company), the supplementation with the replenisher for the decreased pH during power-off (while electric power is cut down) is conducted immediately after the power is turned on.

The automatic processor was used for 8 hours per one day to develop 100m² of the plate and then the machine was switched off for 16 hours. This operation was continued for one month to determine the total amount of replenisher. In addition, the developing performance and printing durability were evaluated by collecting a plate periodically.

The developing performance was determined by determining the reproducibility of the dot images 2 to 98% and removability of the light-sensitive layer at the non-exposed area. The plates in Examples 1 to 3 and in Comparative Example 1 were developed completely at the non-exposed area and thus the developing performance of all the plates had no problem.

Printing durability for the lithographic printing plates was evaluated under the following conditions. Printer: 4 color tower-type rotary press for printing newspaper, CT7000 (170,000 machine) (available from Tokyo Machinery Co. Ltd.). Ink: a printing ink for news paper (available from Dainippon Ink & Chemicals, Inc.), dampening water: News King Alky for newspaper (available from Toyo Ink MFG, Co. Ltd., pH =10.2), paper: 44g/m² available from Oji Paper Co. Ltd., blanket: MP-75R, 2.07mm (available from Kinyosha Co. Ltd.). Under the condition, the lithographic printing plates were used for printing process and the number of printings (number of the printed sheets) obtained before the dot loss is observed was recorded as an index for printing durability. Thus, higher number (sheets) indicates higher printing durability.

The developing performance and printing durability of the lithographic printing plate prepared with a developer which had been used for 3000 m² of the plate was almost the same as those of the lithographic printing plate prepared with a fresh developer, during one month. In addition, when the replenisher of the present invention was used and the developer was exchanged once a month, it was not necessary to exchange the pump for supplementation of the developer due to its trouble during a year.

In contrast, the result of the use of the conventional replenisher (Comparative Example 1) indicates the deterioration of printing durability.

In addition, as shown in Table 2, the total amount of replenisher utilized during one month could be reduced. Thus, the cost for the process, including the processing of waste, could be largely reduced.

**Table 1**

| ingredients | developer | replenisher | | | |
|---|---|---|---|---|---|
| | | Example 1 | Example 2 | Example 3 | Comparative Example 1 |
| KOH*¹ (g) (KOH ratio*²) | 0.13 | 2.75 (21.2) | 1.56 (12.0) | 3.90 (30.0) | 1.22 (9.4) |
| New Coal B13*³ (g) | 5.00 | 5.00 | 5.00 | 5.00 | 5.00 |
| Chelest 400*⁴ (g) | 0.16 | 0.16 | 0.16 | 0.16 | 0.16 |
| Water (g) | 94.71 | 92.09 | 93.28 | 90.94 | 93.62 |
| pH(25°C) | 12.0 | 13.4 | 13.1 | 13.6 | 13.0 |

| | | | | | |
|---|---|---|---|---|---|
| *1 : 48%, available from Nippon Chemical Industrial Co. Ltd. | | | | | |
| *2 : The ratio of the amount of KOH in replenisher to the amount of K OH in developer | | | | | |
| *3 : 2-ethyleneglycol(n=13)-naphthalene, available from Nippon Nyukazai Co. Ltd. | | | | | |
| *4 : Ethylendiaminetetraacetic acid sodium salt, available from Chelest Corporation | | | | | |

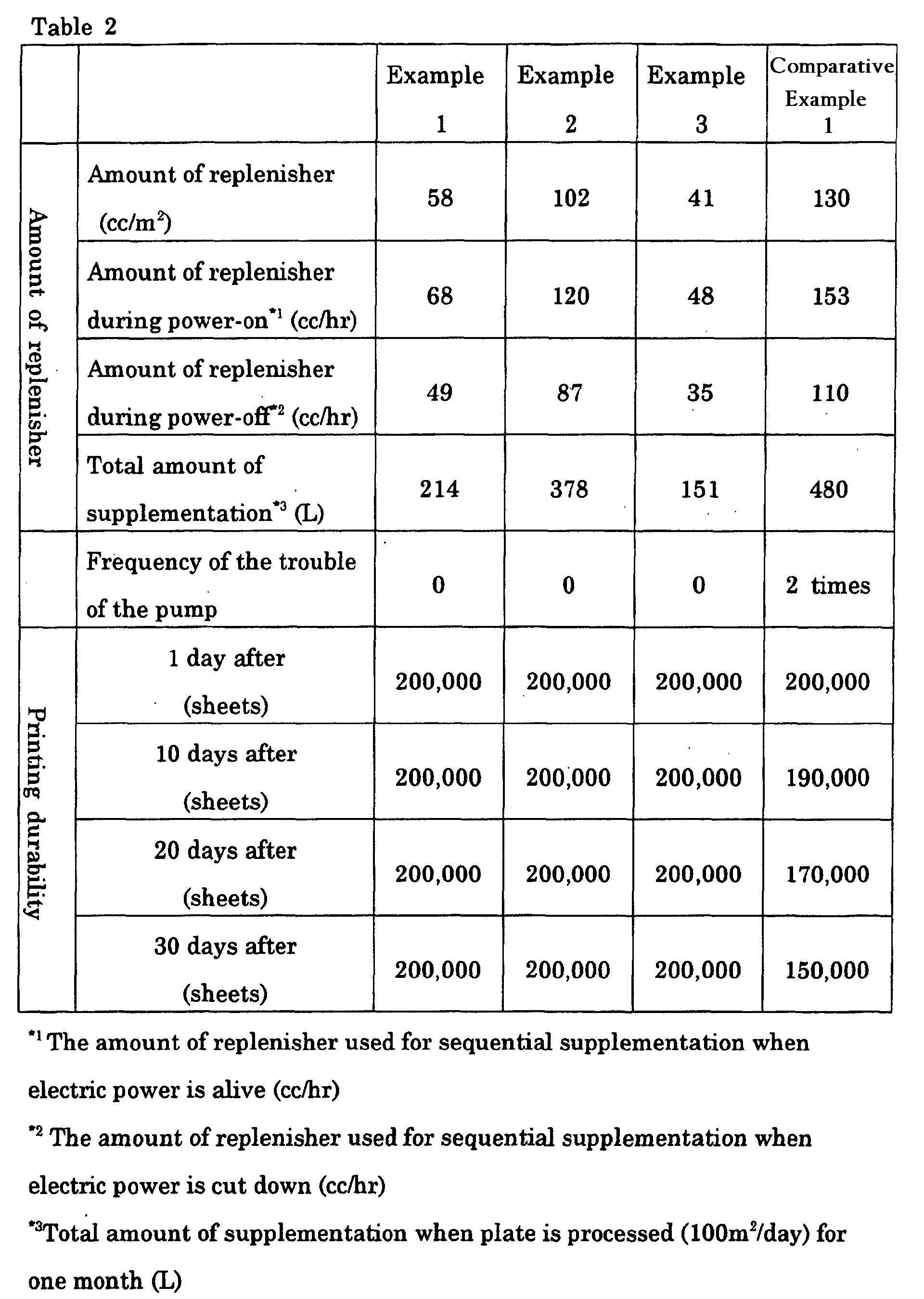

### [Example 4]

The process described in Example 1 was repeated except that polyoxyethylenemethyl phenyl ether (n=10) was used in place of the surfactant in the developer and replenisher in Example 1, for one month. The pH of the developer and replenisher was the same with those as in Example 1, that is, 12.0 and 13.4, respectively. The lithographic printing plate obtained show good developing performance and printing durability for one month. The evaluated printing durability was 200,000 sheets. During one month, printing durability was not deteriorated.

### [Example 5]

The process in Example 1 was repeated except that A2 was used in place of A1 as an ethylenically unsaturated double bond-containing compound in photopolymerizable composition. The lithographic printing plate was obtained by conducting exposure and development in the same manner as in Example 1 and the obtained lithographic printing plate was evaluated for one month. Both the printing durability and developing performance were good. The evaluated printing durability was 200,000 sheets. During one month, printing durability was not deteriorated.

(A2) (CH₂=CHCOOCH₂)₃-CCH₂OH

### [Example 6]

The following composition for intermediate layer was mixed and stirred for 30°C. After 5 minutes, exothermic reaction was observed. After 60 minutes, the content was transferred to another container and additional 30,000 parts by weight of methanol was added to the container to prepare a coating solution for the intermediate layer.

### (Composition for intermediate layer)

| | |
|---|---|
| PHOSMER PE available from Uni-Chemical Co., Ltd. | 20 parts by weight |
| Methanol | 130 parts by weight |
| Water | 20 parts by weight |
| p-Toluene-sulfonic acid | 5 parts by weight |
| Tetra-ethoxy-silane | 50 parts by weight |
| 3-Methacryloxypropyl trimethoxy-silane | 50 parts by weight |

The coating solution for the intermediate layer was coated on the anodized aluminum substrate in Example 1 in such an amount that the amount of Si was equal to about 0.003 g/m² followed by drying the coated layer at 100°C for one minute to form an intermediate layer. Then the light-sensitive layer and water-soluble resin layer were formed thereon as in Example 1. Further, the thus prepared PS plate was exposed to light and developed to form a lithographic printing plate and the plate was evaluated during one month, as in Example 1. The evaluated printing durability was 200,000 sheets. During one month, printing durability was not deteriorated.

### [Example 7]

The process in Example 1 was repeated except that a polymer (methacrylic acid:allyl methacrylate = 30:7, Mw=50,000) was used in place of polyurethane resin in Example 1 to prepare a PS plate. The PS plate was processed as described in Example 1 and printing durability and developing performance of the thus obtained lithographic printing plate were evaluated The evaluated printing durability was 180,000 sheets. During one month, printing durability was not deteriorated.

As clearly seen from the Examples, the method using the conventional replenisher resulted in the deterioration in the printing durability, while the method of the present invention using the replenisher having a higher concentration of alkali agent resulted in no deterioration (conservation) in the printing durability. Although the rational of the effect is not well established, the reason for the improvement of the printing durability in the present invention can be explained as follows. It should be noted, however, the present invention is not bound to the rational.

Generally, crud or precipitation generates in a developer when the developer is used for processing many plates. Thus, such crud or precipitation in the developer makes the printing durability of a plate deteriorated. While surfactant in a developer, which permeates into the image layer of the plate to swell the layer to cause deterioration of the printing durability, may be consumed after many plates are processed with the developer. Thus, the decrease of a surfactant in the developer makes the printing durability of a plate increased.

When the conventional replenisher is used to supplement the developer, the amount of the surfactant in the developer may be maintained at the constant level since the replenisher comprises a specific amount of surfactant. As the result, the printing durability of a plate processed with a developer supplemented with the conventional replenisher may be deteriorated due to the generation of crud or precipitation in the developer, as described above.

In contrast, when the replenisher having a higher concentration of alkali agent is used according to the present invention, the amount of the surfactant in the developer supplemented with the replenisher may be decreased since the surfactant in the developer is consumed and the total amount of the surfactant in the replenisher supplemented is not so much (because the total amount of the replenisher is not so much as shown in Table 2). Thus, the printing durability may be increased by the effect of the decrease of the surfactant. But as described above, the printing durability may be decreased due to the crud or precipitation in the developer. Therefore, the effect of the decrease of surfactant (that is, increase of the printing durability) is set off by the effect of the generation of crud or precipitation in the developer (that is, decrease of the printing durability). As the result, when a plate was processed with the developer supplemented with a replenisher according to the present invention, the printing durability of the plate is maintained at almost the same level as that of the plate processed with a fresh developer.

### Effect of the Invention

A lithographic printing plate showing stable developing performance and good printing durability after long-term use can be obtained at a low cost by the method of the present invention.

## Claims

1. A method for making a lithographic printing plate comprising imagewise exposing to light a presensitized plate useful for making a lithographic printing plate comprising a photopolymerizable composition comprising an ethylenically unsaturated double bond-containing compound, a photopolymerization initiator and a polymer binder on an aluminum substrate, and developing the imagewise exposed plate with a developer comprising an alkali agent, wherein the developer is supplemented with a replenisher comprising an alkali agent in a concentration of at least 12 times as much as the initial concentration of alkali agent in the developer.

2. The method of claim 1, wherein the initial amount of the alkali agent in the developer is in the range of 0.001 to 0.4 mol/l.

3. The method of claim 1 or 2, wherein the replenisher comprises an alkali agent in a concentration of 15 to 50 times as much as the initial amount of alkali agent in the developer.

4. The method of claim 1, wherein the pH of the developer is in the range of 11.5 to 12.4 at 25°C and the pH of the replenisher is in the range of 12.6 to 13.8 at 25°C.

5. The method of any one of claims 1 to 4, wherein the replenisher further comprises a surfactant.

6. The method of claim 5, wherein the surfactant is a nonionic surfactant comprising a polyoxyalkylene ether group.

7. The method of claim 5 or 6, wherein the replenisher comprises the surfactant in an amount ranging from 1 to 30% by weight.

8. The method of claim 5 or 6, wherein the developer comprises a surfactant and the concentration of the surfactant in the replenisher is 20 to 600% as much as the concentration of the surfactant in the developer.

9. The method of any one of claims 1 to 8, wherein the polymer binder is a polyurethane resin binder.

10. The method of claim 9, wherein the polyurethane resin binder is a polymer comprising a structure derived from a reaction product of at least one diisocyanate compound represented by formula (1)' and at least one diol compound represented by formula (1)".
OCN-Xo-NCO (1)'
HO-Yo-OH (1)ʺ
wherein, Xo and Yo independently represent a residue of a divalent organic group.

11. The method of claim 9 or 10, wherein the polyurethane resin binder comprises carboxyl groups in an amount of 4.0 meq/g or more.

12. The method of claims 1 to 11, wherein an oxygen barrier protection layer is overlaid on the presensitized plate useful for making a lithographic printing plate.

## Patentansprüche

1. Verfahren zur Herstellung einer Lithographiedruckplatte, das die bildweise Belichtung einer vorsensibilisierten Platte mit Licht,. die zur Herstellung einer Lithographiedruckplatte geeignet ist, und eine photopolymerisierbare Zusammensetzung umfaßt, die eine ethylenisch ungesättigte doppelbindungshaltige Verbindung, einen Photopolymerisationsinitiator und ein Polymerbindemittel auf einem Aluminiumsubstrat umfaßt, und die Entwicklung der bildweise belichteten Platte mit einem Entwickler, der ein alkalisches Mittel umfaßt, umfaßt, wobei der Entwickler mit einer Auffrischlösung nachgefüllt wird, die ein alkalisches Mittel in einer Konzentration umfaßt, die mindestens dem 12-fachen der anfänglichen Konzentration des alkalischen Mittels in dem Entwickler entspricht.

2. Verfahren gemäß Anspruch 1, worin die anfängliche Menge des alkalischen Mittel in dem Entwickler im Bereich von 0,001 bis 0,4 mol/l liegt.

3. Verfahren gemäß Anspruch 1 oder 2, worin die Auffrischlösung ein alkalisches Mittel in einer Konzentration umfaßt, die dem 15- bis 50-fachen der anfänglichen Menge des alkalischen Mittels in dem Entwickler entspricht.

4. Verfahren gemäß Anspruch 1, worin der pH-Wert des Entwicklers im Bereich von 11,5 bis 12,4 bei 25°C liegt, und der pH-Wert der Auffrischlösung liegt im Bereich von 12,6 bis 13,8 bei 25°C.

5. Verfahren gemäß mindestens einem der Ansprüche 1 bis 4, worin die Auffrischlösung ferner ein Tensid umfaßt.

6. Verfahren gemäß Anspruch 5, worin das Tensid ein nichtionisches Tensid ist, das eine Polyoxyalkylenethergruppe umfaßt.

7. Verfahren gemäß Anspruch 5 oder 6, worin die Auffrischlösung ein Tensid in einer Menge von 1 bis 30 Gew.% umfaßt.

8. Verfahren gemäß Anspruch 5 oder 6, worin der Entwickler ein Tensid umfaßt, und die Konzentration des Tensids in der Auffrischlösung beträgt 20 bis 600 % der Konzentration des Tensids im Entwickler.

9. Verfahren gemäß mindestens einem der Ansprüche 1 bis 8, worin das Polymerbindemittel ein Polyurethanharz-Bindemittel ist.

10. Verfahren gemäß Anspruch 9, worin das Polyurethanharz-Bindemittel ein Polymer ist, das eine Struktur umfaßt, die von einem Reaktionsprodukt mindestens einer Diisocyanatverbindung der Formel (1)' und mindestens einer Diolverbindung der Formel (1)" abgeleitet ist:
OCN-Xo-NCO (1)'
HO-Yo-OH (1)ʺ
worin Xo und Yo unabhängig voneinander einen Rest einer divalenten organischen Gruppe darstellen.

11. Verfahren gemäß Anspruch 9 oder 10, worin das Polyurethanharz-Bindemittel Carboxylgruppen in einer Menge von 4,0 mäq/g oder mehr umfaßt.

12. Verfahren gemäß Anspruch 1 bis 11, worin die vorsensibilisierte Platte, die zur Herstellung einer Lithographiedruckplatte geeignet ist, mit einer Sauerstoffbarrieren-Schutzschicht überzogen ist.

## Revendications

1. Procédé de fabrication d'une plaque d'impression lithographique comprenant d'exposer à la façon d'une image à la lumière une plaque présensibilisée utile pour faire une plaque d'impression lithographique comprenant une composition photopolymérisable comprenant un composé contenant une double liaison insaturée de manière éthylénique, un initiateur de photopolymérisation et un liant polymère sur un substrat d'aluminium, et de développer la plaque exposée à la façon d'une image avec un révélateur comprenant un agent alcalin, où le révélateur est complété avec un régénérateur comprenant un agent alcalin dans une concentration d'au moins 12 fois celle de la concentration initiale d'agent alcalin dans le révélateur.

2. Procédé de la revendication 1, dans lequel la quantité initiale de l'agent alcalin dans le révélateur est dans la gamme de 0,001 à 0,4 mol/l.

3. Procédé de la revendication 1 ou 2, dans lequel le régénérateur comprend un agent alcalin dans une concentration de 15 à 50 fois celle de la quantité initiale d'agent alcalin dans le révélateur.

4. Procédé de la revendication 1, dans lequel le pH du révélateur est dans la gamme de 11,5 à 12,4 à 25 °C et le pH du régénérateur est dans la gamme de 12,6 à 13,8 à 25 °C.

5. Procédé de l'une quelconque des revendications 1 à 4, dans lequel le régénérateur comprend en plus un tensioactif.

6. Procédé de la revendication 5, dans lequel le tensioactif est un tensioactif non ionique comprenant un groupe polyoxyalkylène éther.

7. Procédé de la revendication 5 ou 6, dans lequel le régénérateur comprend le tensioactif dans une quantité se situant dans la gamme de 1 à 30 % en poids.

8. Procédé de la revendication 5 ou 6, dans lequel le révélateur comprend un tensioactif et la concentration du tensioactif dans le régénérateur est de 20 à 600 % celle de la concentration du tensioactif dans le révélateur.

9. Procédé de l'une quelconque des revendications 1 à 8, dans lequel le liant polymère est un liant de résine de polyuréthane.

10. Procédé de la revendication 9, dans lequel le liant de résine de polyuréthane est un polymère comprenant une structure dérivée d'un produit de réaction d'au moins un composé de diisocyanate représenté par la formule (1)' et d'au moins un composé diol représenté par la formule (1)''.
OCN-Xo-NCO (1)'
HO-Yo-OH (1)ʺ
où Xo et Yo représentent indépendamment un résidu d'un groupe organique divalent.

11. Procédé de la revendication 9 ou 10, dans lequel le liant de résine de polyuréthane comprend des groupes carboxyle dans une quantité de 4,0 meq/g ou plus.

12. Procédé des revendications 1 à 11, dans lequel une couche de protection barrière à oxygène est revêtue sur la plaque présensibilisée utile pour fabriquer une plaque d'impression lithographique.
